# EUROPÄISCHE PATENTSCHRIFT

(11) **EP 1 725 088 B1**
(45) Veröffentlichungstag und Bekanntmachung des Hinweises auf die Patenterteilung: **30.03.2011**
(21) Anmeldenummer: 06010048.4
(22) Anmeldetag: 16.05.2006
(51) Int. Cl.: H05K 9/00

(54) **Elektromagnetische Abschirmung**
EMI schielding
Blindage électromagnétique

(30) Priorität: 17.05.2005 DE 102005023344
(43) Veröffentlichungstag der Anmeldung: 22.11.2006
(73) Patentinhaber: Kessel, Wolfgang, 22941 Bargteheide (DE)
(72) Erfinder: Kessel, Wolfgang, 22941 Bargteheide (DE)
(74) Vertreter: Vollmann, Heiko

(56) Entgegenhaltungen:
- WO-A-2004/020930
- DE-A1- 2 537 814
- DE-U1-202004 012 893
- US-A- 5 008 486

## Beschreibung

Die Erfindung betrifft eine elektromagnetische Abschirmung für einen Raum oder ein Gebäude.

Bekannte elektromagnetische Abschirmungen dienen dazu, elektromagnetische Wellen, wie sie typischerweise bei der drahtlosen Funkkommunikotion eingesetzt werden, aus Gebäuden oder Gebäudeteilen abzuhalten bzw. umgekehrt sicherzustellen, dass elektromagnetische Strahlung aus dem Raum oder Gebäude nicht nach außen dringt. Sie sind allerdings nicht dazu geeignet, technische Einrichtungen wie typischerweise ein Atomkraftwerk vor einem nuklearen elektromagnetischen Impuls (NEMP) oder einem anderen elektromagnetischen Impuls hoher Amplitude (HEMP - high altitude electro magnetic pulse) zu schützen. Ein solcher elektromagnetischer Impuls tritt typischerweise beim Auslösen einer nuklearen Kettenreaktion in der Luft auf, wenn beispielsweise eine Atom- oder Wasserstoffbombe über dem Boden gezündet wird oder aber durch gezielte punktuelle Erzeugung (HPM - high power microwave). Die dabei entstehende elektromagnetische Strahlung ist so stark, dass sie sämtliche elektronischen Schaltungen in weitem Umkreis durch Induzierung entsprechend hoher Ströme in den Schaltungen stört oder zerstört. Um wichtige technische Einrichtungen oder kritische Prozesssteuerungen, wie sie typischerweise in Atomkraftwerken zu führen sind gegen Ausfall aufgrund eines z. B. nuklearen elektromagnetischen Impulses zu schützen, sind bisher keine praktikablen elektromagnetischen Abschirmungen bekannt, die dies vermögen. Insbesondere stellt sich das Problem, dass solche elektromagnetischen Abschirmungen zum Beispiel bei bestehenden Atomkraftwerken nachtröglich vorgesehen werden müssen.

Aus DE 37 81 272 T2 ist es bekannt, ein Gebäude dadurch elektromagnetisch abzuschirmen, dass die Seitenwände mit Platten versehen werden, in denen sich Metallgitter befinden, wobei die Metallgitter benachbarter Platten elektrisch leitend miteinander und mit dem Erdpotential verbunden werden. Die dort beschriebene Abschirmung ist allerdings in keiner Weise geeignet, den nuklearen elektromagnetischen Impuls (NEMP) einer nuklearen Kettenreaktion soweit zu dämpfen, dass die innerhalb der Abschirmung befindlichen Flektronikbauteile dies unbeschadet überstehen. Dies ist auch nicht Ziel und Zweck der dort beschriebenen Abschirmung, diese soll vielmehr dazu dienen, elektromagnetische Strahlung, wie sie typischerweise durch Funksignale entsteht, abzuhalten, und zwar sowohl von innen nach außen als auch von außen nach innen.

Aus DE 196 48 544 Al ist eine Abschirmung gegen elektromagnetische Strahlung bekannt, die aus einer Vielzahl überlappend angeordneter und leitend miteinander verbundener elektrisch leitender Geflecht-, Gitter- oder Folienabschnitten besteht. Diese Abschnitte sind überlappend angeordnet und im Überlappungsbereich frei von elektrischer Isolation und dort verklebt, um eine elektrische Verbindung herzustellen. Diese Klebverbindungen haben sich jedoch als problematisch erwiesen, da sie in der Regel nicht in der Lage sind, die erforderliche gut leitende elektrische Verbindung über die gesamte Länge der überlappenden Abschnitte zu gewährleisten. Jedoch dort, wo keine oder eine mangelhafte Verbindung der Abschnitte besteht, ist die Wirksamkeit der Abschirmung mehr oder weniger stark eingeschränkt und somit mangelhaft.

Aus US 5,008,486 ist eine Abschirmung bekannt, die mit Paneelen arbeitet, welche mit elektrisch leitendem Geflecht ummantelt sind. Die Paneele sind über Nut- und Federverbindungen miteinander verbunden, wodurch auch die elektrische Kontaktierung erfolgt. Der Aufbau ist schon aufgrund der Paneelanordnung aufwändig, insbesondere, wenn die Paneele hinsichtlich ihrer Größe den örtlichen Gegebenheiten angepasst werden müssen. Auch ist die elektrische Verbindung einer Sichtkontrolle nicht zugänglich.

Bei der aus DT 25 37 814 A1 bekannten Abschirmung werden eigensteife Geflechtabschnitte überlappend verbaut, die Kontaktierung im Überlappungsbereich stellt eine potentielle Schwachstelle dar. Die Eigensteifigkeit des Materials setzt zudem einen erhöhten Materialeinsatz voraus, was kostenaufwändig ist.

Aus WO 2004/020930 A2 ist eine Abschirmung bekannt, bei der Gitter- oder Geflechtabschnitte überlappend nebeneinander angeordnet werden. Auch hier stellt die Kontaktierung im Überlappungsbereich einen Schwachpunkt dar.

Vor diesem Hintergrund liegt der vorliegenden Erfindung die Aufgabe zugrunde, eine elektromagnetische Abschirmung für einen Raum oder für ein Gebäude zu schaffen, welche eine hohe Dämpfung über weite Frequenzbereiche bewirkt, wie dies z. B. MIL-STD 188-125 Teil 1 und 2 fordert und insbesondere zur zuverlässigen Abschirmung beispielsweise eines Atomkraftwerkes gegen NEMP oder gegen HEMP oder HPM dienen kann, die jedoch auch nachträglich an vorhandenen Gebäuden angebracht werden kann.

Diese Aufgabe wird gemäß der Erfindung durch die im Anspruch 1 angegebenen Merkmale gelöst. Vorteilhafte Ausgestaltungen sind in den Unteransprüchen, der nachfolgenden Beschreibung und der Zeichnung angegeben.

Die erfindungsgemäße elektromagnetische Abschirmung kann sowohl für einen einzelnen Raum als auch für ein komplettes Gebäude dienen und besteht aus überlappend angeordneten und leitend miteinander verbundenen elektrisch leitenden Geflecht- oder Gitterabschnitten, die mit dem Erdpotential verbunden sind. Die Geflechtabschnitte sind im Überlappungsbereich gefalzt ausgebildet, wobei die Falze benachbarter Geflecht- oder Gitterabschnitte im Querschnitt hakenförmig ineinander greifen.

Grundgedanke der vorliegenden Erfindung ist es also, nicht nur elektrisch leitende Geflecht- oder Gitterabschnitte elektrische leitend miteinander zu verbinden, beispielsweise über Kabel, sondern die Geflecht- oder Gitterabschnitte flöchig, vorzugsweise über ihre gesamte Länge und Breite jeweils überlappend mit dem benachbarten Abschnitt anzuordnen und zu verbinden. Um im Überlappungsbereich eine elektrisch gut leitende Verbindung über möglichst die gesamte Länge der Überlappung zu gewährleisten, ist gemäß der Erfindung hier der Geflecht- oder Gitterabschnitt im Überlappungsbereich gefalzt ausgebildet, d. h. im Randbereich um 180° umgebogen, wobei die Falze benachbarter Geflecht- oder Gitterabschnitte so angeordnet sind, dass diese im Querschnitt hakenförmig ineinander greifen. Es entstehen dadurch also nicht nur Vierfachüberdeckungen im Überlappungsbereich, sondem offene Taschen, in die jeweils ein Falz des benachbarten Geflecht- oder Gitterabschnitts eingreift, so dass dieser von beiden Seiten kontaktiert wird. Hierdurch entsteht eine Vielzahl von Kontaktstellen zwischen den einzelnen Geflecht- und Gitterabschnitten, welche dafür sorgen, dass quasi ein homogenes Netz um den Raum bzw. um das Gebäude gespannt wird, welches eine hochfrequenzdichte und homogen leitfähige, aus Einzelstücken aufgebaute Abschirmung bildet, in welcher die induzierten Ströme kurzgeschlossen werden, so dass bei geeigneter Dimensionierung eine Dämpfung erzielt werden kann, die ausreichend groß ist, um einen elektromagnetischen Impuls (NEMP) einer nuklearen Kettenreaktion sicher abzuleiten.

Unter Geflecht- oder Gitterabschnitten im Sinne der vorliegenden Erfindung sind Strukturen aus leitenden Stäben oder Drähten zu verstehen, die zu einer engmaschigen Gitter- oder Netzstruktur derart zusammengefügt sind, dass in den Kreuzpunkten leitfähige Verbindungen bestehen, sei es durch Stoffschluss oder durch Kontakt.

Besonders vorteilhaft ist es, wenn die überlappungsbereiche benachbarter Geflecht- oder Gitterabschnitte sich über die gesamte Länge bzw. Breite erstrecken, da dann um den abzuschirmenden Raum bzw. das abzuschirmende Gebäude quasi ein dichtes Gitternetz gelegt wird, das hinsichtlich seiner elektrischen Leitfähigkeit praktisch homogen ist.

Das so gebildete Geflecht oder Gitter besteht aus Metall und zwar vorzugsweise aus Edelstahl, Kupfer oder einer Kupferlegierung. Zwar sind beim Einsatz von Edelstahl aufgrund der gegenüber Kupfer deutlich schlechteren Leitfähigkeit Abstriche hinsichtlich der Dämpfung zu machen, doch wird der Einsatz von Edelstahl zumindest für Anwendungen ausreichen, bei denen nicht notwendigerweise eine Sicherheit gegen NEMP einer nuklearen Reaktion gegeben sein muss. Der Einsatz von Edelstahl hat hingegen den Vorteil, dass die Verarbeitung vergleichsweise einfach ist und dass auch eine Oberflächenverarbeitung außerhalb des Putzes, beispielsweise zwischen Wand und Dämmschicht möglich ist, ohne dass hierunter die Longzeitstabilität der Abschirmung leidet. Darüber hinaus kann das in die Gebäudestruktur eingegliederte Geflecht als Armierung dienen und somit Armierungsfunktion übemehmen.

Um möglichst optimale Dämpfungseigenschaften zu erreichen ist es zweckmäßig, Geflecht- oder Gitterabschnitte aus möglichst reinem Kupfer einzusetzen, allerdings ist es dann für die Langzeitstabilität günstig, wenn diese überlappend angeordneten und leitend miteinander verbundenen Geflecht- oder Gitterabschnitte in eine fest werdende oder aushärtende Schicht, wie beispielsweise einen Putz oder eine Epoxydharzschicht eingebettet werden. Bevorzugt wird das Kupfer mit bis zu 3% mit einem Oxydationsbildner legiert, beispielsweise mit Zinn, Aluminium oder Nickel. Allerdings hat die Qxydbildung keinen merklichen Einfluss auf, die Leitfähigkeit.

Um den Kontaktbereich (Überlappungsbereich) langzeitstabil zu halten, ist es zweckmäßig, diesen nach Möglichkeit kraft- und formschlüssig zu fixieren, was durch eine geeignete mechanische Verbindung erfolgen kann. Hierfür hat sich der Einsatz von metallischen Heftklammern bewehrt, mit denen die Geflecht- oder Gitterabschnitte im Überlappungsbereich kraft- und formschlüssig verbunden sind. Die Heftklammem können dabei entweder aus Kupfer bestehen oder aus verkupfertem Metall, beim Einsatz von Kupfergeflechten. Es versteht sich, dass beim Einsatz anderer Materialien, wie beispielsweise Edelstahl, auch die Heftklammern aus diesem Material gebildet sein können. Dabei werden die Heftklammern so gesetzt, dass sie im Bereich ineinander greifender Falze liegen, so dass mit geeignetem Abstand über die gesamte Über lappungslänge und Breite zusätzlich eine mechanische Verbindung gebildet wird.

Um die so gebildete Abschirmung zu fixieren und langzeitstabil zu halten, wird diese vorteilhaft in eine Putz-, Estrich- oder Bitumenschicht eingebunden, diese kann an der Innenseite eines Raumes oder an der Außenseite eines Gebäudes vorgesehen sein. Vorteilhaft wird ein Putz bzw. Spachtelmasse verwendet, der keine Oxydationsbildner aufweist und eine mittlere Korngröße aufweist, welche kleiner als die Maschenweite der Geflecht- oder Gitterabschnitte ist, um sicherzustellen, dass eine innige Verbindung zwischen der Putz- oder Estrichschicht und dem darin befindlichen Geflecht- oder Gitterabschnitten einerseits und der damit zu verbindenden Wand andererseits erzielt wird. Die Bitumeneinbindung wird vorzugsweise im erdberührten Bereich eingesetzt.

Wenn, wle Engangs erwähnt, die Abschirmung zwischen der eigentlichen Wand und einer Dämmschicht angeordnet ist, dann ist es zweckmäßig, die Dämmschicht mit Kunststoffankem innerhalb der Wand zu befestigen, weiche die Geflecht- oder Gitterabschnitte durchsetzen. Die dadurch in den Geflecht- oder Gitterabschnitten entstehenden Löcher vermindern die Dämpfung/Absorption nur geringfügig, die Kunststoffanker verhindem jedoch die sonst bei Metallankem entstehende Antennenwirkung.

Um eine hohe Absorption durch Kurzschluss einerseits und eine hohe Reflektion andererseits zu erzielen ist es zweckmäßig, die Geflecht- oder Gitterabschnitte so auszubilden, dass die Maschenweite zwischen 0,1 mm und 1 mm beträgt, Dabei sollte die Drahtstärke zwischen 0,05 mm und 0,5 mm, betragen. Besonders vorteilhaft ist es, Geflechtabschnitte aus möglichst reinem Kupferdraht mit einer Drahtstärke zwischen 0,13 mm und 0,15 mm einzusetzen bei einer Maschenweite von 0,35 mm und 0.4 mm. Die Dämpfung der so gebildeten Abschirmung kann noch dadurch erhöht werden, dass beispielsweise zwei oder mehr solcher Abschirmungen übereinander angeordnet und elektrisch leitend miteinander und mit dem Endpotential verbunden werden.

Insbesondere zur Abschirmung des unterhalb der Erdoberfläche liegenden Fundamentbereiches kann es zweckmäßig sein, Gitter- oder Geflechtabschnitte mit einer Maschenweite bis zu 1 cm bei einer Drahtstärke bis zu 5 mm einzusetzen.

Wenn ein bereits bestehendes Gebäude nachträglich mit der erfindungsgemäßen Abschirmung ausgestattet werden soll, beispielsweise ein Atomreaktor, so kann, so weit es den frei liegenden äußeren Gebäudeteil angeht, dies durch Anbringung einer Abschirmung im Au-Benputz oder durch Integration in Fassaden- oder Dachelemente erfolgen. Eine nachträgliche Abschirmung des Fundaments ist jedoch im Außenbereich praktisch nicht möglich. Es wird dann in solchen Fällen bodenseitig innenliegend eine Abschirmung angebracht, die bis in den Wandbereich hochgezogen wird, so dass dann im Wandbereich überlappend innen und außen eine Abschirmung vorgesehen ist, die über eine Vielzahl von Leitungen elektrisch leitend miteinander verbunden sind. Durch diese Überlappung zwischen Innen- und Außenabschirmung kann eine praktisch geschlossene Abschirmung erzielt werden.

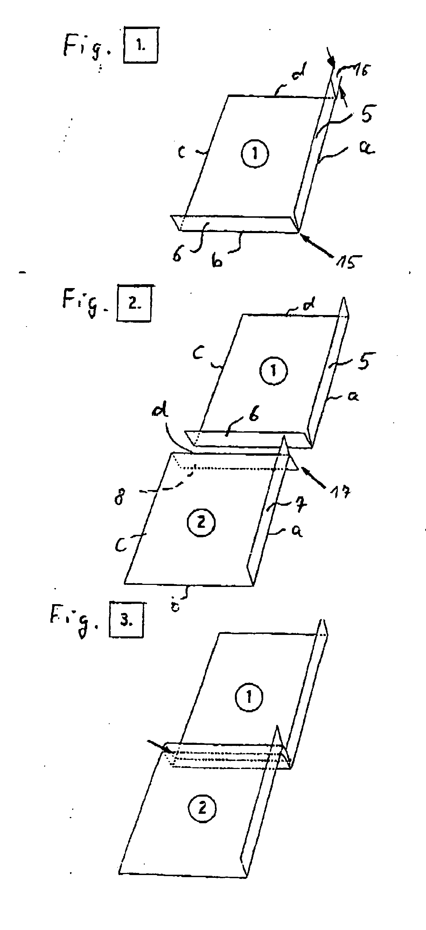

Die Erfindung ist nachfolgend anhand eines in der Zeichnung dargestellten Ausführungsbeispiels näher erläutert. Es zeigen die Fig. 1 bis 10 die Verfahrensschritte, wie eine erfindungsgemäße Abschirmung aus einer Anzahl von Geflecht- oder Gitterabschnitten nebeneinander liegend aufgebaut wird.

Der grundsätzliche Aufbau einer Abschirmung für einen Raum oder für ein Gebäude ist in der Zeichnung nicht im einzelnen dargestellt, er besteht jedoch aus einer Vielzahl von Geflecht- und Gitterabschnitten 1 bis 4, die in der anhand der Figuren dargestellten Weise miteinander überlappend und leitend so verbunden sind, dass sich ein den Raum oder das Gebäude vollständig umgebendes Geflecht oder Gitter ergibt, also an allen Seiten, der Decke und dem Boden, das an mindestens einer Stelle, vorzugsweise jedoch an einer Vielzahl von Stellen mit dem Erdpotential verbunden ist.

Im Bereich von Türen und Fenstem ist dafür Sorge getragen, dass die Gitter- bzw. Geflechtstruktur in ähnlicher Weise realisiert wird, wobei insbesondere auf die dichte und leitende Anlage der zueinander beweglichen Flächen, typischerweise von Fenster- und Türfalzen wert zu legen ist. Dabei kann die Abschirmung wahlweise an der Innen- oder AuBenseite oder an beiden Seiten vorgesehen sein. So wird bei der Abschirmung von Räumen vorteilhaft die Abschirmung an der Innenseite vorgesehen, wohingegen bei Gebäuden die Abschirmung an der Außenseite bevorzugt ist.

Der grundsätzliche Aufbau einer aus Gitter- oder Geflechtabschnitten gebildeten Abschirmung wird nachfolgend erläutert. Bei den in den Figuren dargestellten Ausführungsbeispiels werden rechteckig Abschnitte aus Kupferdrahtgeflecht eingesetzt, wobei der Kupferdraht eine Drahtstärke von 0,14 mm und das Geflecht eine Maschenweite von 0,375 mm aufweist.

Ein erster Geflechtabschnitt 1 rechteckiger Form wird an einer Längsseite a sowie einer Querseite b gefalzt. Hierzu wird zunächst in einem Bereich 15, in welchem die Längsseite a und die Querseite b aufeinander stoßen und, in dem der spätere Falz entstehen soll, ein rechteckiges der Falzbreite 16 entsprechendes Stück entfernt, wonach dann das Material um 90° nach oben gebogen wird, so dass aus den Randbereichen des Geflechtabschnitts 1 ein Längsfalz 5 und ein Querfalz 6 entstehen, die gegenüber dem übrigen Material um 90° nach oben stehen.

Der so bearbeitete Geflechtabschnitt 1 wird an der Wand, Decke oder dem Boden fixiert, wonach ein zweiter Geflechtabschnitt 2 ebenfalls in Form einer rechteckigen Bahn an seiner im Randbereich zwischen den Seiten a und d gebildeten Ecke 17 ausgeschnitten und nachfolgend umgebogen wird. Dabei wird im Bereich der Längsseite a ein Falz 7 um 90° nach oben abgebogen und im Bereich der Querseite d ein Falz 8 um 90° nach unten.

Der Falz 8 wird dann hinter den Falz 6 des Geflechtabschnitts, 1 verbracht, so dass die Falze 5 und 7 in einer Ebene liegen und die Falze 6 und 8 aneinander anliegen, jedoch übergreifend, wie dies in Fig. 3 dargestellt ist.

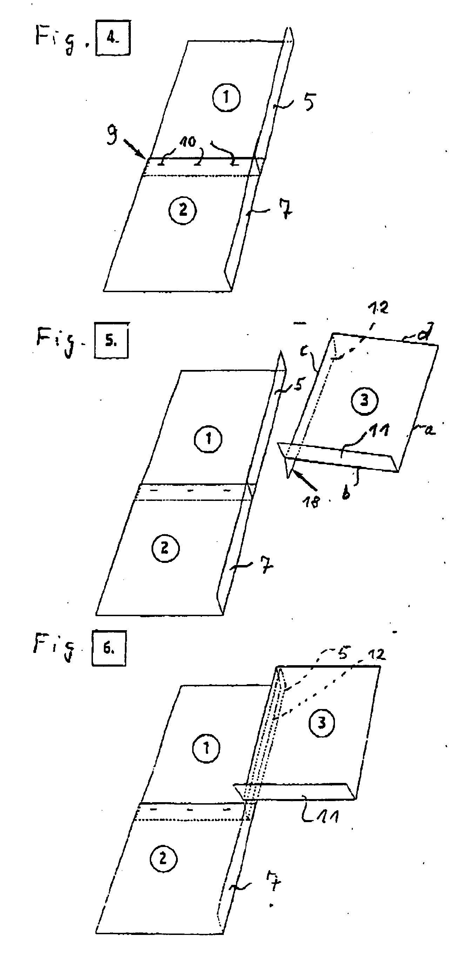

Die Falze 6 und 8 werden dann weiter, und zwar jeweils um 180° zum jeweiligen Grundmaterial abgebogen, derart, dass sie im Querschnitt wie zwei Haken ineinander greifen, so dass sich eine insgesamt vierfache Überlappung in diesem Bereich ergibt. Dieser so überlappte Bereich 9 wird dann mittels Heftklammem 10 fixiert, welche drei bzw, vier Lagen (je nach verwendetem Klammergerät) des Geflechtes durchsetzen und miteinander dauerhaft und fest verbinden. Die Heftklammem 10 werden in geeignetem, nicht zu großem Abstand nebeneinander angebracht, wie dies anhand von Fig. 4 dargestellt ist. Dann fluchten die Falze 5 und 7 zu einem gemeinsamen Falz dieses nun aus zwei Geflechtabschnitten 1 und 2 bestehenden Gebildes.

Es wird nun ein weiterer Geflechtabschnitt 3 vorbereitet, der im Bereich 18 zwischen seiner Querseite b und seiner Längsseite c im Randbereich ausgeschnitten wird, wonach der Randbereich der Seite b zu einem Falz 11 um 90° nach oben und der Randbereich der Seite c zu einem Falz 12 um 90° nach unten abgebogen wird, wie dies in Fig. 5 dargestellt ist.

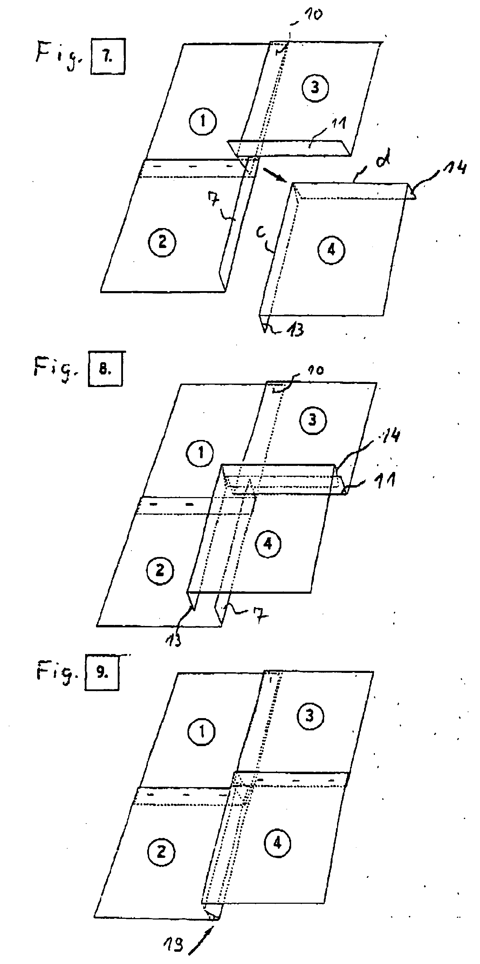

Der Geflechtabschnitt 3 wird dann mit seinem nach unten ragenden Falz 12 über den Geflechtabschnitt 1 mit seinem nach oben ragenden Falz 5 gelegt, so dass die Falze 5 und 12 aneinander liegen, wobei der Falz 5 mit seiner oberen Stirnseite an der Unterseite des Geflechtabschnitts 3 und der Falz 12 mit seiner unteren Stirnseite an der Oberseite des Geflechtabschnitts 1 anliegt. In dieser Stellung, die in Fig. 6 dargestellt ist, werden die Falze 12 und 5 jeweils um weitere 90° abgebogen, so dass sie jeweils um 180° zum jeweiligen Grundmaterial abgebogen sind und im Querschnitt hakenförmig ineinander greifen. Dieser Bereich der übereinander liegenden Falze 5 und 12 mit dem darüber bzw. darunter liegenden Grundmaterial der Geflechtabschnitte 1 und 2 wird in gleicher Weise wie vorbeschrieben durch Heftklammem 10 fixiert, von denen in Fig. 7 beispielhaft nur eine dargestellt ist. Es versteht sich, dass Anzahl und Anordnung der Heftklammern so zu wählen ist, dass ein inniger gut leitender Verbund über die gesamte Fläche des Überlappungsbereichs entsteht,

Sodann wird ein vierter Geflechtabschnitt 4 im Randbereich 19 zwischen seiner Längsseite c und der Querseite d ausgeschnitten, wonach an der Längsseite c der Randbereich zu einem Falz 13 um 90° nach unten abgebogen wird, wohingegen der Randbereich an der Querseite d zu einem Falz 14 ebenfalls um 90° nach unten abgebogen wird. Das so entstandene Gebilde (Fig. 7) wird über die drei bereits miteinander verbundenen Geflechtabschnitte 1 bis 3 gehoben, deren Falze 11 und 7 nach oben vorstehen, derart, dass die Falze 14 und 11 sowie die Falze 7 und 13 aneinander liegen und zwar so, dass die nach unten weisende Stirnseite des Falzes 14 auf der Oberseite des Gewebeabschnitts 3 und die nach oben weisende Stirnseite des Falzes 11 an der Unterseite des Geflechtabschnitts 4 anliegt, in analoger Weise die Falze 7 und 13.

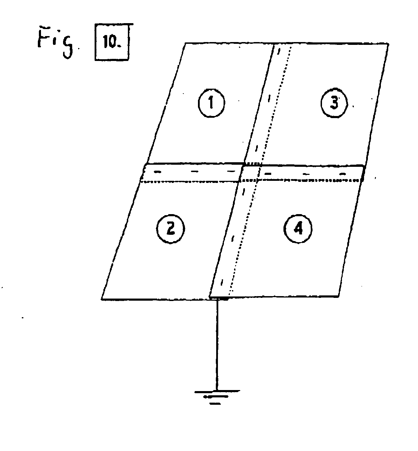

Es werden dann, die Falze 11 und 14 um weitere 90° umgebogen, so dass sie im Querschnitt hakenförmig ineinander greifen, wonach auch in diesem Bereich Hettklommem 10 gesetzt und damit die Fafzverbindung fixiert wird (Fig. 9). Schließlich werden die noch senkrecht stehenden aber schon ebenfalls ineinander greifenden Falze 7 und 13 um weitere 90° auf insgesamt 180° abgebogen und in dieser Stellung durch Heftklammern 10 fixiert, so dass sich das in Fig. 10 schematisch dargestellte flächige Gebilde aus insgesamt vier Geftechtabschnitten 1 bis 4 entsteht.

Auf die vorbeschriebene Weise können beliebig viele Geflechtabschnitte miteinander verbunden werden. Wie die Darstellungen zeigen, sind alle Geflechtabschnitte an Ihren Längsseiten a mit einem nach oben um 90° abgebogenen Falz und an den Längsseiten c mit einem nach unten abgebogenen Falz versehen. Darüber hinaus ist an der oberen Querseite d stets ein nach unten abgebogener Falz und an der unteren Querseite b stets ein nach oben abgebogener Falz vorgesehen. Die Falzung um 90°, wie vorbeschrieben, kann also schon vor der Montage erfolgen.

Bei dem vorbeschriebenen Material ist einerseits eine hohe Flexibilität gegeben, so dass auch schon an der Wand, der Decke oder dem Boden fixierte Geflechtabschnitte randseitig angehoben werden können, andererseits jedoch eine gute Plastizität gegeben so, dass der letzte vor Ort zu erfolgende Falzvorgang, nämlich das Abbiegen um 90° auf 180°, von Hand erfolgen kann, ohne dass hierzu besondere Werkzeuge erforderlich sind. Die plastische Verformung erfolgt durch einfaches Umbiegen von Hand.

### Bezugszelchenllste

- 1, 2, 3, 4: Geflechtabschnitt
- a: Längsseite rechts
- b: Querseite unten
- c: Längsseite links
- d: Querseite oben
- 5.6: Falz von 1
- 7.8: Falz von 2
- 9: Überlappungsbereich
- 10: Heftklammern
- 11,12: Falz von 3
- 13,14: Falz von 4
- 15: Bereich
- 16: Falzbreite
- 17: Ecke
- 18: Bereich
- 19: Bereich

## Patentansprüche

1. Elektromagnetische Abschirmung für einen Raum oder ein Gebäude bestehend aus überlappend angeordneten und leitend miteinander verbundenen elektrisch leitenden Geflecht- oder Gitterabschnitten (1-4), die mit dem Erdpotential elektrisch verbunden sind, **dadurch gekennzeichnet, dass** die Geflecht- oder Gitterabschnitte (1-4) im Überlappungsbereich (9) gefalzt ausgebildet, das heißt im Randbereich um 180° umgebogen, sind, wobei die Falze (6, 8) benachbarter Geflecht- oder Gitterabschnitte (1, 2) so angeordnet sind, dass diese im Querschnitt hakenförmig ineinander greifen, wobei Vierfachüberdeckungen im Überlappungsbereich und offene Taschen entstehen, in die jeweils ein Falz des benachbarten Geflecht- oder Gitterabschnitts (1-4) eingreift, so dass dieser von beiden Seiten kontaktiert wird.

2. Elektromagnetische Abschirmung nach Anspruch 1, **dadurch gekennzeichnet, dass** benachbarte Geflecht- oder Gitterabschnitte (1, 2; 1, 3; 3, 4; 2, 4) über ihre gesamte Länge und Breite überlappen.

3. Elektromagnetische Abschirmung nach Anspruch 1, **dadurch gekennzeichnet, dass** die Geflecht- oder Gitterabschnitte (1-4) den abzuschirmenden Raum oder das abzuschirmende Gebäude zu allen Seiten vollständig umgeben.

4. Elektromagnetische Abschirmung nach einem der vorhergehenden Ansprüche, **dadurch gekennzeichnet, dass** die Geflecht- oder Gitterabschnitte (1-4) aus Metall, vorzugsweise aus Edelstahl, Kupfer oder einer Kupferlegierung bestehen.

5. Elektromagnetische Abschirmung nach einem der vorhergehenden Ansprüche, **dadurch gekennzeichnet, dass** die Geflecht- oder Gitterabschnitte (1-4) eine Maschenweite zwischen 0,1 mm und 1 mm aufweisen.

6. Elektromagnetische Abschirmung nach einem der vorhergehenden Ansprüche, **dadurch gekennzeichnet, dass** die Geflecht- oder Gitterabschnitte (1 - 4) aus Metalldraht mit einer Drahtstärke zwischen 0,05 mm und 0,5 mm bestehen.

7. Elektromagnetische Abschirmung nach einem der vorhergehenden Ansprüche, **dadurch gekennzeichnet, dass** die Geflecht- oder Gitterabschnitte (1-4) aus Kupferdraht mit einer Drahtstärke zwischen 0,13 mm und 0,15mm bestehen und eine Maschenweite zwischen 0,35 mm und 0,40 mm aufweisen.

8. Elektromagnetische Abschirmung nach einem der vorhergehenden Ansprüche, **dadurch gekennzeichnet, dass** die Geflecht- oder Gitterabschnitte im Fundamentbereich aus Kupferdraht mit einer Drahtstärke von bis zu 5 mm bestehen und eine Maschenweite von bis zu 1 cm aufweisen.

9. Elektromagnetische Abschirmung nach einem der vorhergehenden Ansprüche, **dadurch gekennzeichnet, dass** die Geflecht- oder Gitterabschnitte (1-4) im Überlappungsbereich (9), vorzugsweise im Bereich ineinander greifender Falze (6, 8) mechanisch miteinander verbunden sind.

10. Elektromagnetische Abschirmung nach einem der vorhergehenden Ansprüche, **dadurch gekennzeichnet, dass** die Geflecht- oder Gitterabschnitte (1-4) im Überlappungsbereich (9) vorzugsweise im Bereich ineinander greifender Falze (6, 8) durch metallische Heftklammern (10) miteinander kraft- und formschlüssig verbunden sind.

11. Elektromagnetische Abschirmung nach einem der vorhergehenden Ansprüche, **dadurch gekennzeichnet, dass** die miteinander verbundenen Geflecht- oder Gitterabschnitte (1-4) durch eine diese durchsetzende Putz-, Spachtel-, Estrich- oder Bitumenschicht an der Innen- oder Außenseite von Wand, Decke oder Boden befestigt sind.

12. Elektromagnetische Abschirmung nach einem der vorhergehenden Ansprüche, **dadurch gekennzeichnet, dass** die Geflecht- oder Gitterabschnitte (1-4) an der Außenseite einer Wand oder Decke angebracht und von einer Wärmedämmschicht überdeckt sind, wobei die Wärmedämmschicht mittels Kunststoffanker an der Wand befestigt ist, welche die Abschirmung durchsetzen.

## Claims

1. An electromagnetic shielding for a room or a building, consisting of electrically conductive plaiting sections or mesh sections (1-4) which are arranged in an overlapping manner, are conductively connected to one another and are electrically connected to earth potential, **characterised in that** the plaiting or mesh sections (1-4) in the overlapping region (9) are formed in a folded manner, which means are bent by 180° in the edge region, wherein the folds (6, 8) of adjacent plaiting or mesh section (1, 2) are arranged such that these in cross section engage into one another in a hook-like manner, wherein multiple coverings in the overlapping region and open pockets arise, into which in each case a fold of the adjacent plaiting section or mesh section (1-4) engages, so that this is contacted from both sides.

2. An electromagnetic shielding according to claim 1, **characterised in that** adjacent plaiting sections or mesh sections (1, 2: 1, 3; 3, 4; 2, 4) overlap over their whole length and width.

3. An electromagnetic shielding according to claim 1, **characterised in that** the plaiting sections or mesh sections (1-4) surround the room to be shielded or the building to be shielded, on all sides in a complete manner.

4. An electromagnetic shielding according to one of the preceding claims, **characterised in that** the plaiting section or mesh sections (1-4) consist of metal, preferably stainless steel, copper or a copper alloy.

5. An electromagnetic shielding according to one of the preceding claims, **characterised in that** the plaiting sections or mesh sections (1-4) have a mesh width between 0.1 mm and 1 mm.

6. An electromagnetic shielding according to one of the preceding claims, **characterised in that** the braiding or mesh sections (1-4) consist of metal wire with a wire thickness between 0.05 mm and 0.5 mm.

7. An electromagnetic shielding according to one of the preceding claims, **characterised in that** the plaiting sections or mesh sections (1-4) consist of copper wire with a wire thickness between 0.13 mm and 0.15 mm and have a mesh width between 0.35mm and 0.40 mm.

8. An electromagnetic shielding according to one of the preceding claims, **characterised in that** the plaiting sections or mesh sections in the foundation region consist of copper wire with a wire thickness of up to 5 mm and a mesh width of up to 1 cm.

9. An electromagnetic shielding according to one of the preceding claims, **characterised in that** the plaiting sections or mesh sections (1-4) in the overlapping region (9), preferably in the region of folds (6, 8) engaging into one another, are connected mechanically to one another.

10. An electromagnetic shielding according to one of the preceding claims, **characterised in that** the braiding or mesh sections (1-4) in the overlapping region (9), preferably in the region of folds (6, 8) engaging into one another, are connected to one another with a non-positive and positive fit by way of metallic staples (10).

11. An electromagnetic shielding according to one of the preceding claims, **characterised in that** the braiding or mesh sections (1-4) which are connected to one another are fastened by way of a plaster layer, putty layer, floor layer or bitumen layer, on the inner side or outer side of wall ceiling or floor, said layer passing through the braiding or mesh sections.

12. An electromagnetic shielding according to one of the preceding claims, **characterised in that** the braiding or mesh sections (1-4) are attached on the outer side of a wall or ceiling and are covered by a heat-insulating layer, wherein the heat insulating layer is fastened on the wall by way of plastic anchors which pass through the shielding.

## Revendications

1. Blindage électromagnétique pour un espace ou un bâtiment, comprenant des portions de treillis ou de grille (1-4) électro-conductrices, disposées à chevauchement et interconnectées de façon à conduire le courant, qui sont reliées électriquement au potentiel de terre, **caractérisé en ce que** les portions de treillis ou de grille (1-4) sont pliées dans la zone de chevauchement (9), c'est-à-dire repliées de 180° dans la région de bord, les plis (6, 8) de portions de treillis ou de grille (1-4) adjacentes étant agencés de façon à s'imbriquer en section transversale à la manière d'un crochet, créant de quadruples chevauchements dans la zone de chevauchement et des poches ouvertes dans lesquelles s'engage respectivement un pli de la portion de treillis ou de grille (1-4) adjacente de façon que celle-ci soit mise en contact des deux côtés.

2. Blindage électromagnétique selon la revendication 1, **caractérisé en ce que** des portions de treillis ou de grille adjacentes (1, 2 ; 1, 3 ; 3, 4 ; 2, 4) se chevauchent sur toute leur longueur et largeur.

3. Blindage électromagnétique selon la revendication 1, **caractérisé en ce que** les portions de treillis ou de grille (1-4) entourent intégralement de tous côtés l'espace ou le bâtiment à protéger.

4. Blindage électromagnétique selon l'une des revendications précédentes, **caractérisé en ce que** les portions de treillis ou de grille (1-4) sont en métal, de préférence en acier spécial, en cuivre ou alliage de cuivre.

5. Blindage électromagnétique selon l'une des revendications précédentes, **caractérisé en ce que** les portions de treillis ou de grille (1-4) présentent une maille de largeur comprise entre 0,1 mm et 1 mm.

6. Blindage électromagnétique selon l'une des revendications précédentes, **caractérisé en ce que** les portions de treillis ou de grille (1-4) sont en fil métallique d'une épaisseur comprise entre 0,05 mm et 0,5 mm.

7. Blindage électromagnétique selon l'une des revendications précédentes, **caractérisé en ce que** les portions de treillis ou de grille (1-4) sont en fil de cuivre d'une épaisseur comprise entre 0,13 mm et 0,15 mm et présentent une maille de largeur comprise entre 0,35 mm et 0,40 mm.

8. Blindage électromagnétique selon l'une des revendications précédentes, **caractérisé en ce que** les portions de treillis ou de grille dans la zone des fondations sont constituées de fil de cuivre d'une épaisseur allant jusqu'à 5 mm et présentent une maille de largeur allant jusqu'à 1 cm.

9. Blindage électromagnétique selon l'une des revendications précédentes, **caractérisé en ce que** les portions de treillis ou de grille (1-4) sont reliés entre elles mécaniquement dans la zone de chevauchement (9), de préférence dans la région de plis (6, 8) en prise mutuelle.

10. Blindage électromagnétique selon l'une des revendications précédentes, **caractérisé en ce que** les portions de treillis ou de grille (1-4) sont reliés entre elles par liaison de force et complémentarité de forme par des agrafes métalliques (10) dans la zone de chevauchement (9), de préférence dans la région de plis (6, 8) en prise mutuelle.

11. Blindage électromagnétique selon l'une des revendications précédentes, **caractérisé en ce que** les portions de treillis ou de grille (1-4) reliées entre elles sont fixées par une couche d'enduit, masse d'égalisation, chape ou bitume les traversant sur la face intérieure ou la face extérieure des murs, plafonds ou planchers.

12. Blindage électromagnétique selon l'une des revendications précédentes, **caractérisé en ce que** les portions de treillis ou de grille (1-4) sont disposées sur la face extérieure d'un mur ou d'un plafond et sont recouvertes d'une couche d'isolation thermique, la couche d'isolation thermique étant fixée sur le mur au moyen d'ancres plastiques qui traversent le blindage.
